# EUROPEAN PATENT SPECIFICATION

(11) **EP 3 004 534 B1**
(45) Date of publication and mention of the grant of the patent: **25.04.2018**
(21) Application number: 14720430.9
(22) Date of filing: 26.03.2014
(51) Int. Cl.: E21B 43/26

(54) **SYSTEM AND METHOD FOR CHARACTERIZING UNCERTAINTY IN SUBTERRANEAN RESERVOIR FRACTURE NETWORKS**
SYSTEM UND VERFAHREN ZUR CHARAKTERISIERUNG VON UNSICHERHEIT IN BRUCHNETZWERKEN IN UNTERIRDISCHEN LAGERSTÄTTEN
SYSTÈME ET PROCÉDÉ DE CARACTÉRISATION D'INCERTITUDE DANS DES RÉSEAUX DE FRACTURES DE RÉSERVOIRS SOUTERRAINS

(30) Priority: 29.05.2013 US 201313904180
(43) Date of publication of application: 13.04.2016
(73) Proprietor: Chevron U.S.A. Inc., San Ramon, CA 94583 (US)
(72) Inventor: SARKAR, Sudipta, San Ramon, California 94583 (US); CHAWATHE, Adwait, San Ramon, California 94583 (US)
(74) Representative: Haseltine Lake LLP
(86) International application number: PCT/US2014/031879
(87) International publication number: WO 2014/193529

(56) References cited:
- WO-A1-2012/058028
- US-A1- 2011 120 706
- ULRICH ZIMMER: "Calculating Stimulated Reservoir Volume (SRV) with Consideration of Uncertainties in Microseismic-Event Locations", PROCEEDINGS OF CANADIAN UNCONVENTIONAL RESOURCES CONFERENCE, 15 November 2011 (2011-11-15), pages 1-13, XP055162582, DOI: 10.2118/148610-MS ISBN: 978-1-61-399149-7
- S C MAXWELL ET AL: "GeoConvention 2013: Integration Simulation of Microseismic Deformation During Hydraulic Fracturing", CSPG CSEG CWLS JOINT ANNUAL CONVENTION [GEOCONVENTION 2013] (CALGARY, CANADA), 6 May 2013 (2013-05-06), pages 1-4, XP055162681,
- SUDIPTA SARKAR ET AL: "Uncertainty in microseismic event source locations associated with a fracture stimulation in a tight sand", ISTANBUL 2012, INTERNATIONAL GEOPHYSICAL CONFERENCE AND OIL & GAS EXHIBITION, 17 September 2012 (2012-09-17), pages 1-4, XP055162579, DOI: 10.1190/IST092012-001.142

## Description

### FIELD OF THE INVENTION

The present invention relates generally to methods and systems for characterizing fracture networks in subterranean reservoirs and, in particular, methods and systems for characterizing the uncertainty in a stimulated reservoir volume.

### BACKGROUND OF THE INVENTION

One of the challenges for completing wells in unconventional reservoirs such as shales and tight sands is successfully connecting the hydraulically-induced fractures with the natural fracture system, thereby significantly increasing the effective drainage volume, also referred to as the Stimulated Reservoir Volume (SRV). A large SRV infers high production for that well. Unfortunately, identifying and integrating the appropriate static (geological, petrophysical, geophysical, etc.) and dynamic (pumping, production, etc.) datasets and understanding the inherent uncertainty in those datasets makes it difficult to quantify the uncertainty in the SRV (and hence the production potential of a well). Appropriate quantification of the SRV will allow optimization of hydraulic fracturing stages and design, and the number of wells being drilled, resulting in significant cost savings.

Estimates of the SRV rely primarily on microseismic measurements. By locating microseismic events recorded during a hydraulic fracturing job, one can get useful information about the height, growth, size and directionality of the induced hydraulic fracture. Microseismic events may also be used to monitor fracture growth which allows microseismic data to be used to provide approximate estimates of the SRV. Although microseismic measurements are made routinely, industry-standard data gathering and processing of the microseismic data is lacking, resulting in a large uncertainty in quality of the results.

In addition to making actual microseismic measurements, SRV quantification could be done using geomechanical/hydraulic fracturing simulators that predict microseismic response given static and dynamic information. Such simulators are now available in the market but a clear and streamlined workflow does not exist whereby a user can identify and integrate appropriate static and dynamic data along with the measured microseismic data in the simulator to characterize the uncertainty in the SRV. The current art uses ad-hoc procedures which result in a single, poorly defined SRV, and completely ignores the large uncertainty associated with it.

Reference may be made to a paper by U. Zimmer entitled "Calculating Stimulated Reservoir Volume (SRV) with Consideration of Uncertainties in Microseismic-Event Locations", Canadian Unconventional Resources Conference 2011.

Reference may be made to US 2011/0120706 A1, which relates to refining information on subterranean fractures.

### SUMMARY OF THE INVENTION

Described herein are implementations of various approaches for a computer-implemented method for characterizing uncertainty in a subsurface region of interest.

A computer-implemented method for characterizing uncertainty in a subsurface region of interest is disclosed.

The present invention is defined by the independent claims, to which reference should now be made.

Specific embodiments are defined in the dependent claims.

The above summary section is provided to introduce a selection of concepts in a simplified form that are further described below in the detailed description section. The claimed subject matter is not limited to implementations that solve any or all disadvantages noted in any part of this disclosure.

### BRIEF DESCRIPTION OF THE DRAWINGS

These and other features of the present invention will become better understood with regard to the following description, claims and accompanying drawings where:
Figure 1 is a flowchart illustrating a method in accordance with an embodiment of the present disclosure;
Figure 2 is an illustration of an embodiment of the present disclosure;
Figure 3 is a demonstration of a step of an embodiment of the present disclosure;
Figure 4 is a demonstration of a step of an embodiment of the present disclosure;
Figure 5 is a demonstration of a step of an embodiment of the present disclosure; and
Figure 6 schematically illustrates a system for performing a method in accordance with an embodiment of the disclosure.

### DETAILED DESCRIPTION OF THE INVENTION

The present invention may be described and implemented in the general context of a system and computer methods to be executed by a computer. Such computer-executable instructions may include programs, routines, objects, components, data structures, and computer software technologies that can be used to perform particular tasks and process abstract data types. Software implementations of the present invention may be coded in different languages for application in a variety of computing platforms and environments. It will be appreciated that the scope and underlying principles of the present invention are not limited to any particular computer software technology.

Moreover, those skilled in the art will appreciate that the present disclosure may be practiced using any one or combination of hardware and software configurations, including but not limited to a system having single and/or multiple processor computers, hand-held devices, tablet devices, programmable consumer electronics, mini-computers, mainframe computers, and the like. The disclosure may also be practiced in distributed computing environments where tasks are performed by servers or other processing devices that are linked through one or more data communications network. In a distributed computing environment, program modules may be located in both local and remote computer storage media including memory storage devices.

Also, non-transitory processor readable medium for use with a computer processor, such as a CD, pre-recorded disk or other equivalent devices, may include a program means recorded thereon for directing the computer processor to facilitate the implementation and practice of the present disclosure. Such devices and articles of manufacture also fall within the scope of the present invention as defined by the claims.

Referring now to the drawings, embodiments of the present disclosure will be described. The disclosure can be implemented in numerous ways, including, for example, as a system (including a computer processing system), a method (including a computer implemented method), an apparatus, a computer readable medium, a computer program product, a graphical user interface, a web portal, or a data structure tangibly fixed in a computer readable memory. Several embodiments of the present disclosure are discussed below. The appended drawings illustrate only typical embodiments of the present disclosure and therefore are not to be considered limiting of its scope and breadth.

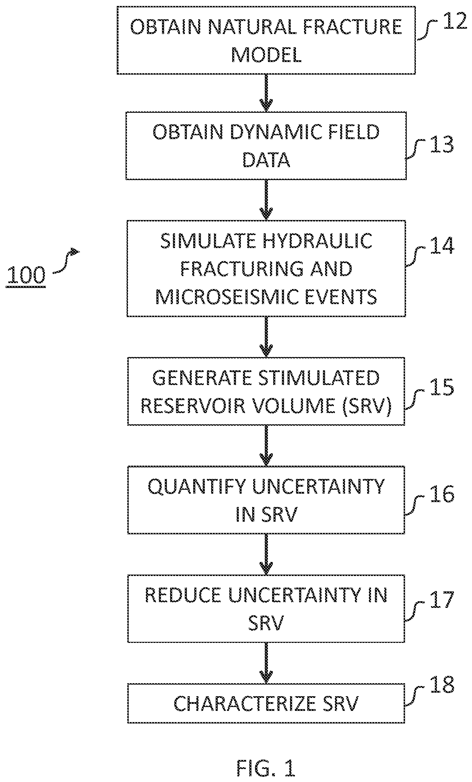

The present disclosure relates to characterizing uncertainty in a subterranean region of interest. One embodiment of the present disclosure is shown as method 100 in Figure 1. At operation 12, a natural fracture model of the subterranean region of interest is obtained. This natural fracture model may be based, for example, on knowledge of local or analog geology, stress information, well logs, seismic data, and/or core data. These examples are not meant to be limiting. One skilled in the art will appreciate that there are a number of possible ways to obtain the natural fracture model. The natural fracture model may have been generated prior to operation 12 and simply supplied to the method at operation 12. It may also be generated as part of operation 12.

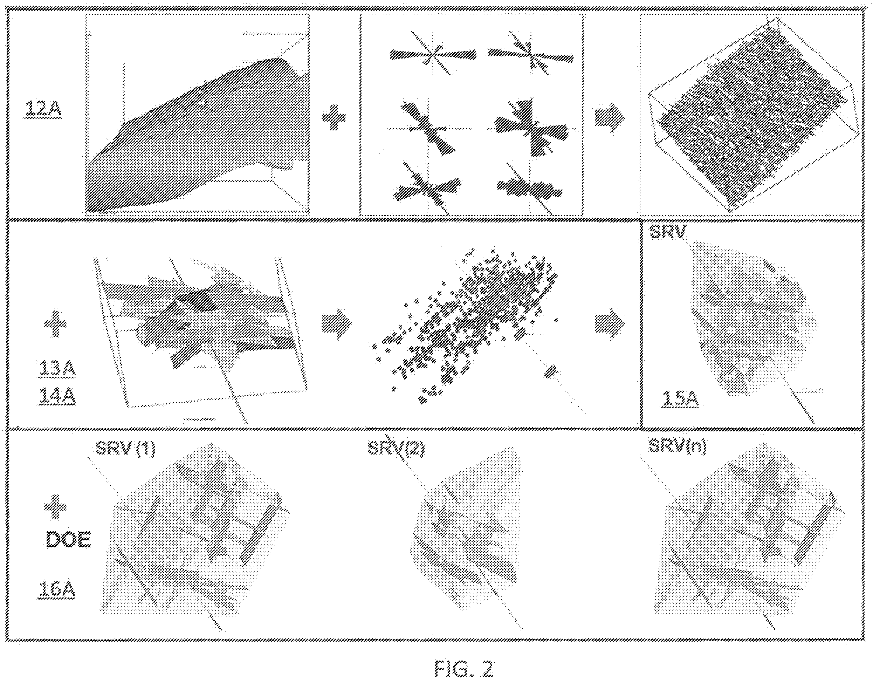

If the natural fracture model is generated at operation 12, it may be created using a software package such as FracMan or Fraca, or other methods known to those skilled in the art. In one embodiment, the natural fracture framework might be generated from geology, well logs, seismic data, and/or core data using the Discrete Fracture Network (DFN) technique. The natural fracture model may also be based on stress data and rock property data which may be included in the natural fracture network. The stress data and rock property data may be determined from core data and well logs, particularly including data on breakouts. This allows the natural fracture model to include a representation of the geomechanics of the subterranean region of interest. This is demonstrated in Figure 2 in panel 12A.

Referring again to Figure 1, at operation 13 dynamic field data may be obtained. This dynamic field data may include, for example, fluid flow data, injection pressure, injection volume, and/or injection duration, including pumping pressure and rate. The dynamic field data may be data that was actually used in a field or be parameters input by the user as a simulation of dynamic field data. This is demonstrated in Figure 2 in panel 13A.

The natural fracture model and dynamic field data may be used together at operation 14 to create multi-stage hydraulic fractures and simulate microseismic events generated by the hydraulic fracturing. The microseismic events may occur due to fracture activation or reactivation. This is demonstrated in Figure 2 in panel 14A.

Once the microseismic events have been simulated, the stimulated reservoir volume (SRV) is generated at operation 15. The SRV may be determined, for example, by putting a wrapper around the microseismic events. One skilled in the art will appreciate that there are many ways to generate the SRV. For example, a Convex Hull approach may be used, which often finds an upper-bound estimate of the SRV. Alternatively, a fracture slab approach can yield a lower-bound estimate of the SRV. These examples are not meant to be limiting; any method for defining the SRV based on the simulated microseismic events may be used. This is demonstrated in Figure 2 in panel 15A.

The SRV generated at operation 15 has a high degree of uncertainty depending on the uncertainty of the input data for the natural fracture model and the simulation of the hydraulic fracturing and microseismic events. The uncertainty in the input data may arise from, for example, poor data quality, insufficient quantity of data, poor modeling of the subsurface, poor modeling of the hydraulic fractures, and/or poor simulation of the microseismic events. The uncertainty in the SRV makes it risky for use in estimating potential production volumes, determining optimum hydraulic fracturing plans, and/or determining locations and number of wells to be drilled.

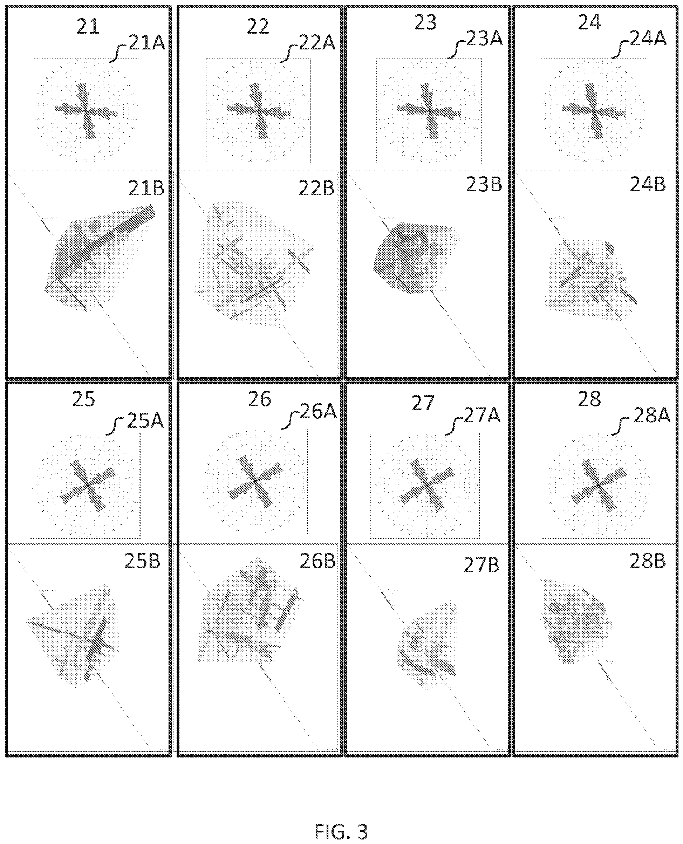

Referring again to Figure 1, at operation 16 the uncertainty in the SRV is quantified. This may be accomplished, for example, by using Design of Experiments (DOE), also called Experimental Design. This process methodically varies one or more parameters to identify the parameters that have the largest impact on the result and, therefore, the greatest influence on the uncertainty. This is demonstrated, for example, in Figure 2 as panel 16A and in Figure 3. In Figure 3, the input parameters for the natural fracture network are being tested. In particular, the natural fracture orientation, natural fracture intensity, and natural fracture size are being changed. Panel 21 shows the orientation 21A of the fractures, which in this example have an intensity of P32∼0.01 and a mean size of 15.24 m (50 ft) resulting in the SRV 21B of 0.0368x10⁷ m³ (1.3x10⁷ ft³); Panel 22 shows the orientation 22A, having an intensity of P32∼0.01 and a mean size of 9.14 m (30 ft) resulting in the SRV 22B of 0.0538x10⁷ m³ (1.9x10⁷ ft³); Panel 23 shows the orientation 23A, having an intensity of P32∼0.05 and a mean size of 15.24 m (50 ft) resulting in the SRV 23B of 0.2605x10⁶ m³ (9.2x10⁶ ft³); Panel 24 shows the orientation 24A, having an intensity of P32∼0.05 and a mean size of 9.14 m (30 ft) resulting in the SRV 24B of 0.2379x10⁶ m³ (8.4x10⁶ ft³); Panel 25 shows the orientation 25A, having an intensity of P32∼0.01 and a mean size of 15.24 m (50 ft) resulting in the SRV 25B of 0.0340x10⁷ m³ (1.2x10⁷ ft³); Panel 26 shows the orientation 26A, having an intensity of P32∼0.01 and a mean size of 9.14 m (30 ft) resulting in the SRV 26B of 0.0453x10⁷ m³ (1.6x10⁷ ft³); Panel 27 shows the orientation 27A, having an intensity of P32∼0.05 and a mean size of 15.24 m (50 ft) resulting in the SRV 27B of 0.2067x10⁶ m³ (7.3x10⁶ ft³); and Panel 28 shows the orientation 28A, having an intensity of P32∼0.05 and a mean size of 9.14 m (30 ft) resulting in the SRV 28B of 0.2605x10⁶ m³ (9.2x10⁶ ft³).

After the uncertainty in the SRV has been assessed at operation 16, this uncertainty may be narrowed at operation 17. This may be accomplished by techniques that use observed microseismicity to help constrain the SRV. These techniques may include but are not limited to finite-difference modeling and clustering algorithms.

Finite-difference modeling may be used to simulate microseismic waveforms (signals) in the natural fracture model. The modeled microseismic waveforms can be compared with those recorded during the actual microseismic survey, which may help narrow the location uncertainty in the microseismic data. Having more accurate microseismic event locations allows the selection of more plausible outcomes of modeled microseismic and SRVs. Finite-difference modeling would also help with understanding of the rock failure modes and microseismic source mechanisms during hydraulic fracturing, which could be used to further constrain stress and natural fracture inputs when obtaining a natural fracture model, as at operation 12.

Many different clustering algorithms may be used to help narrow the uncertainty. Various techniques exist which may be used to identify distinct clusters or features (e.g. fracture planes, lineation) from the observed microseismic "cloud" data. This may help constrain some of the input parameters required for natural fracture modeling as in operation 12. Clustering algorithms would include statistical techniques such as collapsing, centroid determination, and other techniques such as waveform cross-correlation, multiplet analysis, joint-hypocenter determination and double-difference location methods. Any algorithm used to analyze the observed microseismic cloud in order to better constrain the natural fracture model may be used.

It is also possible to further constrain the characterization of SRV by including production or flow data in the Design of Experiment process. Production or flow profiles may be estimated using an appropriate reservoir flow simulator, which may then be compared with observed production data or flow profiles derived from techniques such as well testing, PLT (Production Logging Tool), DTS (Distributed Temperature Sensing), etc even on a hydraulic fracture stage level if such data is available. Such comparison will further narrow down the range of possible SRVs by constraining the model parameters, thereby closing the loop using both static (microseismic-based) and dynamic (flow-based) characterization. At the end, the workflow will help evaluate the efficacy of the completions or hydraulic fracturing program.

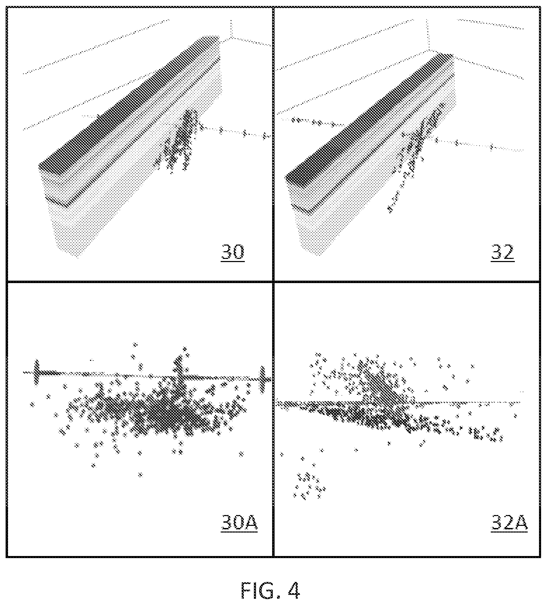

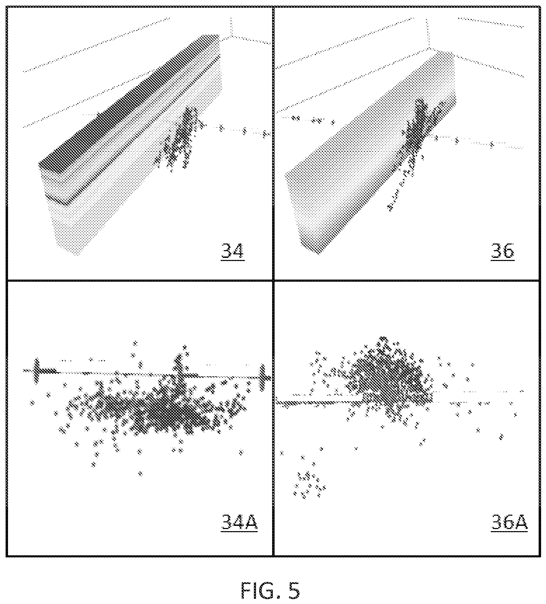

After the SRV has been refined at operation 17, it can be characterized based on observations of the improved SRV against static and dynamic data at operation 18. This is demonstrated in Figures 4 and 5. In these figures, the potential SRVs are shown in panels 30, 32, 34, and 36 for different stages of the hydraulic fracturing along with the modeled microseismic data from operation 14 in Figure 1. The modeled microseismic data is shown as dark gray dots. This is compared with the observed microseismic data which is light gray dots. The microseismic data is also shown in panels 30A, 32A, 34A, and 36A. Panels 30 and 34 and panels 30A and 34A are identical; panels 36 and 36A match the observed microseismic better than panels 34 and 34A. This is a static characterization of the SRVs.

Although the foregoing description and Figure 1 put forth the operations in a linear manner, one skilled in the art will appreciate that many of the operations may be performed concurrently or in a different order. Moreover, it is to be understood that it is possible to repeat operations as more data or results are obtained.

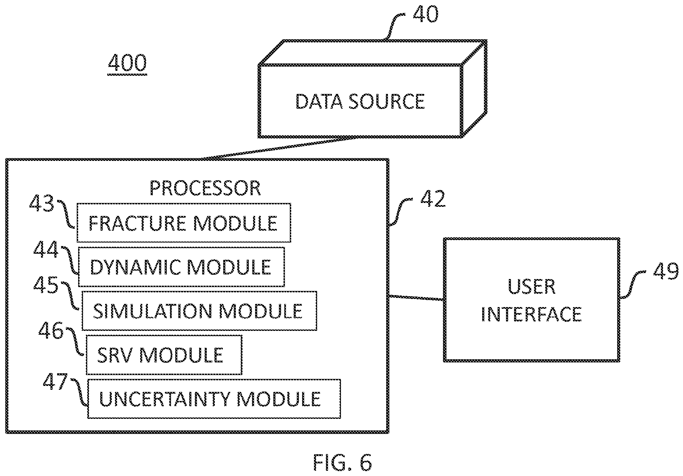

A system 400 for performing the method 100 of Figure 1 is schematically illustrated in Figure 6. The system includes a data source/storage device 40 which may include, among others, a data storage device or computer memory. The data source/storage device 40 may contain recorded seismic data, synthetic seismic data, or signal or noise models. The data from data source/storage device 40 may be made available to a processor 42, such as a programmable general purpose computer. Although this diagram shows a single processor, the use of multiple processors, in one machine or in a distributed environment, is also contemplated for the present invention. The processor 42 is configured to execute computer modules that implement method 100. These computer modules may include a fracture module 43 for obtaining a natural fracture model, either from the data source 40 or by creating one as explained previously; a dynamic module 44 for obtaining dynamic field data; a simulation module 45 for creating hydraulic fractures based on the natural fracture model and dynamic field data and simulating microseismic events; an SRV module 46 for determining a SRV; and an uncertainty module 47 for determining the uncertainty in the SRV. Other modules may be included to implement additional embodiments of the present invention, such as a Design of Experiment module and/or a characterization module. One skilled in the art will appreciate that these modules may be combined in many ways and do not have to be distinct modules; additionally, each module might also be split into two or more parts; any combination of modules that together perform the method of the present invention is within the scope of this system. The system may include interface components such as user interface 49. The user interface 49 may be used both to display data and processed data products and to allow the user to select among options for implementing aspects of the method. By way of example and not limitation, the SRVs computed on the processor 42 may be displayed on the user interface 49, stored on the data storage device or memory 40, or both displayed and stored.

While in the foregoing specification this disclosure has been described in relation to certain preferred embodiments thereof, and many details have been set forth for purpose of illustration, it will be apparent to those skilled in the art that the disclosure is susceptible to alteration and that certain other details described herein can vary considerably without departing from the basic principles of the disclosure. In addition, it should be appreciated that structural features or method steps shown or described in any one embodiment herein can be used in other embodiments as well.

## Claims

1. A computer-implemented method (100) for characterizing uncertainty in a subsurface region of interest, the method comprising:
obtaining (12), at a computer processor (42), a natural fracture model of the subsurface region of interest;
obtaining (13), at the computer processor (42), dynamic field data relating to the subsurface region of interest;
simulating (14), via the computer processor (42), hydraulic fracturing and microseismic events based on the dynamic field data and the natural fracture model;
generating (15), via the computer processor (42), a stimulated reservoir volume based on the simulated microseismic events;
quantifying (16), via the computer processor (42), uncertainty in the stimulated reservoir volume;
obtaining, at the computer processor (42), observed microseismicity data associated with hydraulic fracturing in the subsurface region of interest;
comparing the simulated microseismic events with the observed microseismicity data;
narrowing (17) the uncertainty in the stimulated reservoir volume based on the comparison
of the simulated microseismic events with the observed microseismicity;
simulating production of the subsurface region of interest to generate simulated production data;
obtaining observed production data relating to the subsurface region of interest;
comparing the simulated production data with the observed production data; and
further narrowing (17) the uncertainty in the stimulated reservoir volume based on the comparison with the observed production data, thereby determining a reduced range of possible stimulated reservoir volumes.

2. The method of claim 1, wherein further narrowing (17) the uncertainty in the stimulated reservoir volume comprises producing an improved stimulated reservoir volume.

3. The method of claim 1 or 2 wherein narrowing the uncertainty in the stimulated reservoir volume is done by using a clustering algorithm.

4. The method of claim 1 or 2 wherein narrowing the uncertainty in the stimulated reservoir volume is done by using finite difference modeling.

5. The method of claim 2 further comprising determining (18) a dynamic characterization of the improved stimulated reservoir volume based on dynamic flow data and flow simulation models.

6. The method of any of the preceding claims, wherein the obtaining (12) the natural fracture model comprises:
creating a natural fracture network based on at least one of geology, well logs, seismic data, and core data;
obtaining stress data and rock property data for the subsurface region of interest; and
combining the stress data and the rock property data with the natural fracture network to create the natural fracture model.

7. The method of any of the preceding claims, wherein the natural fracture model is constrained by at least one of well-test data and production data.

8. The method of any of the preceding claims, wherein the quantifying (16) the uncertainty in the stimulated reservoir volume comprises using Design of Experiments.

9. The method of any of the preceding claims, wherein the natural fracture model includes:
natural fracture orientation;
natural fracture intensity; and
natural fracture size.

10. The method of claim 9, wherein reducing a range of uncertainty includes reducing uncertainty in the natural fracture orientation, natural fracture intensity and natural fracture size.

11. A system (400) for characterizing uncertainty in a subsurface region of interest, the system comprising a data source (40) containing data representative of the subsurface region of interest and a computer processor (42) configured to carry out the method of any of the preceding claims.

12. A computer program comprising instructions which, when executed by a computer (42), causes the computer (42) to implement the method for characterizing uncertainty in a subsurface region of interest of any of claims 1 to 10.

13. A computer-readable medium having the computer program of claim 12 stored on it.

## Patentansprüche

1. Rechner-implementiertes Verfahren (100) zur Charakterisierung von Unsicherheit in einem unterirdischen Bereich von Interesse, das Verfahren umfassend
Erhalten (12), an einem Rechnerprozessor (42), eines natürlichen Bruchmodells des unterirdischen Bereichs von Interesse;
Erhalten (13), am Rechnerprozessor (42), von dynamischen Felddaten im Zusammenhang mit dem unterirdischen Bereich von Interesse;
Simulieren (14), über den Rechnerprozessor (42), von hydraulischer Bruchbildung und mikroseismischen Erscheinungen auf der Grundlage der dynamischen Felddaten und des natürlichen Bruchmodells;
Erzeugen (15), über den Rechnerprozessor (42), eines stimulierten Reservoirvolumens auf der Grundlage der simulierten mikroseismischen Erscheinungen;
Quantifizieren (16), über den Rechnerprozessor (42), von Unsicherheit im stimulierten Reservoirvolumen;
Erhalten, am Rechnerprozessor (42), von beobachteten Mikroseismizitätsdaten im Zusammenhang mit hydraulischer Bruchbildung im unterirdischen Bereich von Interesse;
Vergleichen der simulierten mikroseismischen Erscheinungen mit den beobachteten mikroseismischen Erscheinungen;
Eingrenzen (17) der Unsicherheit im stimulierten Reservoirvolumen auf Grundlage des Vergleichs der simulierten mikroseismischen Erscheinungen mit den beobachteten mikroseismischen Erscheinungen;
Simulieren einer Förderung aus dem unterirdischen Bereich von Interesse zum Erzeugen von simulierten Förderdaten;
Erhalten von beobachteten Förderdaten im Zusammenhang mit dem unterirdischen Bereich von Interesse;
Vergleichen der simulierten Förderdaten mit den beobachteten Förderdaten; und
weiteres Eingrenzen (17) der Unsicherheit im stimulierten Reservoirvolumen auf Grundlage des Vergleichs mit den beobachteten Förderdaten, um so einen reduzierten Bereich von möglichen stimulierten Reservoirvolumen zu bestimmen.

2. Verfahren gemäß Anspruch 1, wobei weiteres Eingrenzen (17) der Unsicherheit im stimulierten Reservoirvolumen umfasst Fördern in einem verbesserten stimulierten Reservoirvolumen.

3. Verfahren gemäß Anspruch 1 oder 2, wobei Eingrenzen der Unsicherheit im stimulierten Reservoirvolumen mit Hilfe eines Clustering-Algorithmus erfolgt.

4. Verfahren gemäß Anspruch 1 oder 2, wobei Eingrenzen der Unsicherheit im stimulierten Reservoirvolumen mit Hilfe von Finite-Differenzen-Modelling erfolgt.

5. Verfahren gemäß Anspruch 2, zudem umfassend Bestimmen (18) einer dynamischen Charakterisierung des verbesserten stimulierten Reservoirvolumens auf der Grundlage von dynamischen Flussdaten und Flusssimulationsmodellen.

6. Verfahren gemäß irgendeinem der vorhergehenden Ansprüche, wobei das Erhalten (12) des natürlichen Bruchmodells umfasst
Erzeugen eines natürlichen Bruchnetzwerks auf der Grundlage von mindestens einem aus Geologie, Bohrprofilen, seismischen Daten und Kerndaten;
Erhalten von Spannungsdaten und Gesteinseigenschaftsdaten aus dem unterirdischen Bereich von Interesse; und
Kombinieren der Spannungsdaten und der Gesteinseigenschaftsdaten mit dem natürlichen Bruchnetzwerk zum Erzeugen des natürlichen Bruchmodells.

7. Verfahren gemäß irgendeinem der vorhergehenden Ansprüche, wobei das natürliche Bruchmodell begrenzt wird durch mindestens eines aus Bohrlochtestdaten und Förderdaten.

8. Verfahren gemäß irgendeinem der vorhergehenden Ansprüche, wobei das Quantifizieren (16) der Unsicherheit im stimulierten Reservoirvolumen umfasst Verwendung von statistischer Versuchsplanung.

9. Verfahren gemäß irgendeinem der vorhergehenden Ansprüche, wobei das natürliche Bruchmodell umfasst
natürliche Bruchorientierung;
natürliche Bruchintensität; und
natürliche Bruchgröße.

10. Verfahren gemäß Anspruch 9, wobei Reduzieren eines Bereichs von Unsicherheit einschließt Reduzieren von Unsicherheit in der natürlichen Bruchorientierung, der natürlichen Bruchintensität und der natürlichen Bruchgröße.

11. System (400) zur Charakterisierung von Unsicherheit in einem unterirdischen Bereich von Interesse, das System umfassend eine Datenquelle (40) einschließlich Daten, die den unterirdischen Bereich von Interesse darstellen, und einen Rechnerprozessor (42), ausgelegt zum Ausführen des Verfahrens aus irgendeinem der vorhergehenden Ansprüche.

12. Rechnerprogramm, umfassend Instruktionen, die, wenn durch einen Rechner (42) ausgeführt, dazu führen, dass der Rechner (42) das Verfahren zur Charakterisierung von Unsicherheit in einem unterirdischen Bereich von Interesse aus irgendeinem der Ansprüche 1 bis 10 ausführt.

13. Rechnerlesbares Medium mit dem Rechnerprogramm aus Anspruch 12 darauf abgelegt.

## Revendications

1. Procédé mis en oeuvre sur un ordinateur (100) pour caractériser une incertitude dans une région d'intérêt souterraine, le procédé comprenant :
obtenir (12), sur un processeur d'ordinateur (42), un modèle de fissures naturelles de la région d'intérêt souterraine ;
obtenir (13), sur le processeur d'ordinateur (42), des données dynamiques sur le terrain en relation avec la région d'intérêt souterraine ;
simuler (14), par l'intermédiaire du processeur d'ordinateur (42), de la fracturation hydraulique et des événements microsismiques sur la base des données dynamiques sur le terrain et le modèle de fissures naturelles ;
générer (15), par l'intermédiaire du processeur d'ordinateur (42), un volume de réservoir stimulé sur la base des événements microsismiques simulés ;
quantifier (16), par l'intermédiaire du processeur d'ordinateur (42), une incertitude dans le réservoir stimulé ;
obtenir, sur le processeur d'ordinateur (42), des données observées de microsismicité, associées à la fracturation hydraulique dans la région d'intérêt souterraine ;
comparer les événements microsismiques simulés aux données observées de microsismicité ;
affiner (17) l'incertitude dans le volume de réservoir stimulé à la base de la comparaison des événements microsismiques simulés avec la microsismicité observée ;
simuler une production de la région d'intérêt souterraine pour générer des données de production simulées ;
obtenir des données de production observées en relation avec la région d'intérêt souterraine ;
comparer les données de production simulées aux données de production observées ; et
affiner de davantage (17) l'incertitude dans le volume de réservoir stimulé à la base de la comparaison des données de production observées, en ainsi déterminant une gamme réduite de volumes de réservoir stimulés possibles.

2. Procédé selon la revendication 1, dans lequel affiner davantage (17) l'incertitude dans le volume de réservoir stimulé comprend produire un volume de réservoir stimulé amélioré.

3. Procédé selon la revendication 1 ou 2 dans lequel affiner l'incertitude dans le volume de réservoir stimulé est fait en utilisant un algorithme.

4. Procédé selon la revendication 1 ou 2 dans lequel affiner l'incertitude dans le volume de réservoir stimulé est fait en utilisant la modélisation aux différences finies.

5. Procédé selon la revendication 2 comprenant en plus déterminer (18) une caractérisation dynamique du volume de réservoir stimulé amélioré à base de données de flux dynamique et de modèles de simulation de flux.

6. Procédé selon une quelconque des revendications précédentes, dans lequel obtenir (12) un modèle de fissures naturelles comprend :
créer un réseau de fissures naturelles à base d'au moins un parmi la géologie, les profils de sondage, les données sismiques et les données de base ;
obtenir des données de tension et des données de propriétés des roches pour la région souterraine d'intérêt ; et
combiner les données de tension et les données de propriétés des roches avec le réseau de fissures naturelles pour créer le modèle de fissures naturelles.

7. Procédé selon une quelconque des revendications précédentes, dans lequel le modèle de fissures naturelles est limité par au moins une parmi les données de test de puits et les données de production.

8. Procédé selon une quelconque des revendications précédentes, dans lequel quantifier (16) l'incertitude dans le volume de réservoir stimulé comprend l'utilisation de Conception d'Expériences.

9. Procédé selon une quelconque des revendications précédentes, dans lequel le modèle de fissures naturelles comprend :
orientation de fissure naturelle ;
intensité de fissure naturelle ; et
taille de fissure naturelle.

10. Procédé selon la revendication 9, dans lequel réduire une gamme d'incertitudes comprend réduire l'incertitude dans l'orientation de fissure naturelle, l'intensité de fissure naturelle et la taille de fissure naturelle.

11. Système (400) pour caractériser une incertitude dans une région d'intérêt souterraine, le système comprenant une source de données (40) contenant des données respectives à la région d'intérêt souterraine et un processeur d'ordinateur (42) configuré pour exécuter le procédé d'une quelconque des revendications précédentes.

12. Logiciel d'ordinateur comprenant des instructions qui, si elles sont exécutées par un ordinateur (42), portent l'ordinateur (42) à mettre en oeuvre le procédé pour caractériser une incertitude dans une région d'intérêt souterraine d'une quelconque des revendications 1 à 10.

13. Médium pouvant être lu par un ordinateur ayant le logiciel d'ordinateur de la revendication 12 stocké dessus.
